# EUROPEAN PATENT APPLICATION

(11) **EP 3 226 413 A1**
(43) Date of publication of application: **04.10.2017**
(21) Application number: 15863895.7
(22) Date of filing: 29.06.2015
(51) Int. Cl.: H03H 9/02, H01G 4/12, H01G 4/40

(54) **PIEZOELECTRIC COMPONENT**

(30) Priority: 28.11.2014 JP 2014241715
(71) Applicant: Kyocera Corporation, Kyoto-shi, Kyoto 612-8501 (JP)
(72) Inventor: NAKAMA,Hiroto, Kyoto-shi Kyoto 612-8501 (JP)
(74) Representative: Viering, Jentschura & Partner mbB Patent- und Rechtsanwälte
(86) International application number: PCT/JP2015/068686
(87) International publication number: WO 2016/084417

(57) **Abstract**

There is provided a piezoelectric component that can achieve reduction in oscillation frequency variations, and thus has a highly accurate oscillation frequency. A piezoelectric component of the invention includes a support substrate (1); a piezoelectric element (2) having both ends fixed to a first principal surface of the support substrate (1), being mounted on the first principal surface, so as to be oscillatable; a pair of terminal electrodes (121, 122) located below the ends of the piezoelectric element (2), respectively; a pair of capacitance-forming electrodes (123, 124) each having a greater width than the piezoelectric element (2), extending from the pair of terminal electrodes, respectively, toward a center of the piezoelectric element (2); and excitation electrodes (21) disposed on a first principal surface and a second principal surface of the piezoelectric element (2), respectively, the excitation electrodes (21) facing each other so that a facing region in which the excitation electrodes overlap with each other as seen in a transparent plan view is defined therebetween, at least part of a region of the pair of capacitance-forming electrodes which protrudes outside the facing region in a width direction thereof as seen in a plan view, being covered with an insulating film (6).

## Description

### Technical Field

The present invention relates to a piezoelectric component which is used as a resonator.

### Background Art

Conventionally, as a resonator for clock of a microcomputer, there is known a piezoelectric resonator comprising a support substrate and a piezoelectric element having both ends fixed to the support substrate, being mounted on the support substrate, so as to be oscillatable.

As an increasingly higher degree of precision in oscillation frequency has been demanded in piezoelectric resonators, as a way to attain great precision in oscillation frequency, there is known the use of a technology for frequency regulation using ion beam application to an excitation electrode of a piezoelectric element (refer to Patent Literature 1, for example).

According to the above-described technology, to protect an electrode (electrode for forming capacitance) placed on a support substrate from etching with ion beams during ion beam application, there is adopted a design to avoid placement of the capacitance-forming electrode in a position below an oscillating section of the piezoelectric element, and, there is also adopted a design to make the capacitance-forming electrode smaller in width than the piezoelectric element. This makes it possible to prevent fly-off of part of the capacitance-forming electrode under irradiation of ion beams, and thereby avoid a short-circuit failure problem.

### Citation List

### Patent Literature

Patent Literature 1: Japanese Unexamined Patent Publication JP-A 2005-191681

### Summary of Invention

### Technical Problem

In the above-described technology, however, a decrease in load-carrying capacity may occur, and this leads to an increase in oscillation frequency variations and thus to poor precision in oscillation frequency.

The invention has been devised in view of the circumstances as discussed supra, and accordingly an object of the invention is to provide a piezoelectric component that can achieve reduction in oscillation frequency variations, and thus has a highly accurate oscillation frequency.

### Solution to Problem

The invention provides a piezoelectric component, comprising a support substrate, a piezoelectric element having both ends fixed to a first principal surface of the support substrate, being mounted on the first principal surface, so as to be oscillatable, a pair of terminal electrodes located below the ends of the piezoelectric element, respectively, a pair of capacitance-forming electrodes each having a greater width than the piezoelectric element extend from the pair of terminal electrodes, respectively, toward a center of the piezoelectric element, and excitation electrodes disposed on a first principal surface and a second principal surface of the piezoelectric element, respectively, the excitation electrodes facing each other so that a facing region in which the excitation electrodes overlap with each other as seen in a transparent plan view is defined therebetween, at least part of a region of the pair of capacitance-forming electrodes which protrudes outside the facing region in a width direction thereof as seen in a plan view, being covered with an insulating film.

### Advantageous Effects of Invention

The piezoelectric component pursuant to the invention is capable of reduction in oscillation frequency variations and thus improvement in oscillation frequency precision.

### Brief Description of Drawings

FIG. 1(a) is a schematic plan view, with parts omitted, showing an example of a piezoelectric component of this embodiment, and, FIG. 1(b) is a schematic sectional view of the piezoelectric component taken along the line A-A shown in FIG. 1(a);
FIG. 2(a) is a schematic plan view, with parts omitted, showing another example of the piezoelectric component of this embodiment, and, FIG. 2(b) is a schematic sectional view of the piezoelectric component taken along the line A-A shown in FIG. 2(a); and
FIG. 3(a) is a schematic plan view, with parts omitted, showing still another example of the piezoelectric component of this embodiment, and, FIG. 3(b) is a schematic sectional view of the piezoelectric component taken along the line A-A shown in FIG. 3(a).

### Description of Embodiments

A piezoelectric component in accordance with a present embodiment will be described in detail with reference to drawings.

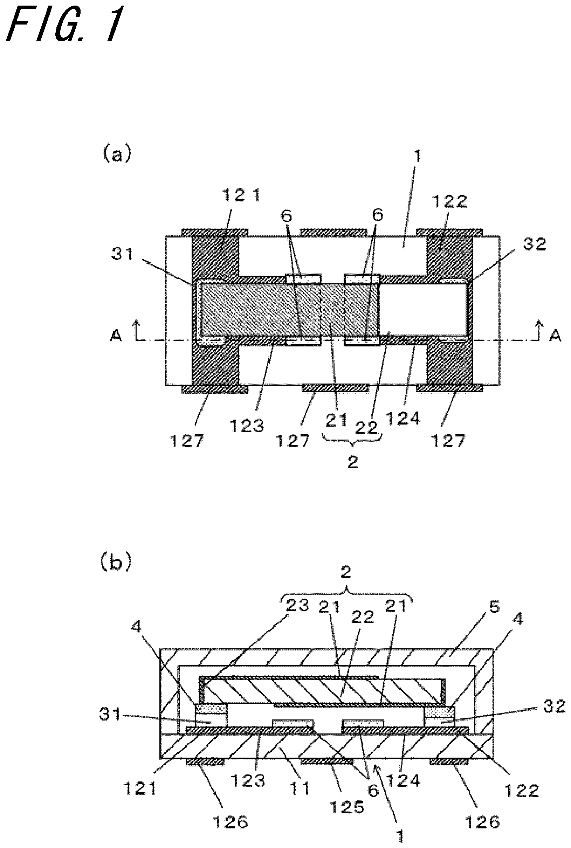

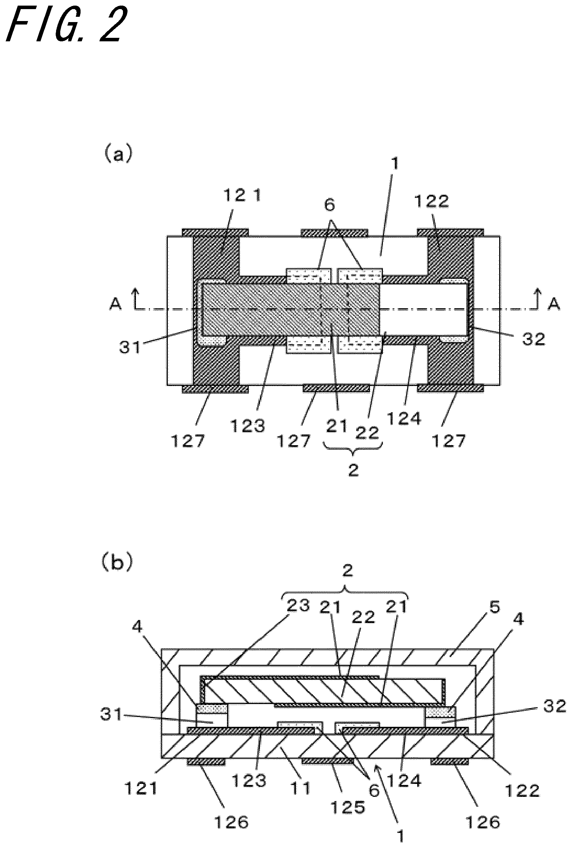

FIG. 1(a) is a schematic plan view of an example of a piezoelectric component of this embodiment (a lid body is omitted), and, FIG. 1(b) is a schematic sectional view of the piezoelectric component taken along the line A-A shown in FIG. 1(a). Moreover, FIG. 2(a) is a schematic plan view, with parts omitted, showing another example of the piezoelectric component of this embodiment, and, FIG. 2(b) is a schematic sectional view of the piezoelectric component taken along the line A-A shown in FIG. 2(a).

The piezoelectric component as exemplified in FIG. 1 comprises a support substrate 1 and an elongated piezoelectric element 2 having both ends fixed to a first principal surface (an upper surface viewing the drawing) of the support substrate 1, being mounted on the first principal surface, so as to be oscillatable. The support substrate 1 has, on the first principal surface thereof, a pair of terminal electrodes (a first terminal electrode 121 and a second terminal electrode 122) located below the ends of the piezoelectric element 2, respectively, and a pair of capacitance-forming electrodes (a first capacitance-forming electrode 123 and a second capacitance-forming electrode 124) each having a greater width than the piezoelectric element 2, extending from the pair of terminal electrodes (the first terminal electrode 121 and the second terminal electrode 122), respectively, toward the center of the piezoelectric element 2. Moreover, the piezoelectric element 2 has excitation electrodes 21 disposed on a first principal surface thereof and a second principal surface thereof opposite to the first principal surface, respectively, and these excitation electrodes 21 face each other so that a facing region in which the excitation electrodes 21 overlap with each other as seen in a transparent plan view is defined therebetween. Moreover, at least part of a region of the pair of capacitance-forming electrodes (the first capacitance-forming electrode 123 and the second capacitance-forming electrode 124) which protrudes outside the facing region in a width direction thereof as seen in a plan view, is covered with an insulating film 6. Although a lid body 5 is omitted from FIG. 1(a), as shown in FIG. 1(b), the piezoelectric component of this embodiment has the lid body 5.

For example, the support substrate 1 comprises a dielectric body 11 shaped in a rectangular flat plate as seen in a plan view, which is 2.5 mm to 7.5 mm in length, 1.0 mm to 3.0 mm in width, and 0.1 mm to 1 mm in thickness. As the dielectric body 11, it is possible to use a ceramic material which is a ferroelectric material containing, for example, lead zirconate titanate or barium titanate as a major constituent.

Lead zirconate titanate is one of ferroelectric substances that exhibit high relative permittivity, and thus allows further increase in load-carrying capacity. Hence, the use of a ferroelectric material containing lead zirconate titanate as a major constituent for the dielectric body 11 constituting the support substrate 1 helps reduce oscillation frequency variations, and is thus conducive to improvement in oscillation frequency precision.

On the other hand, barium titanate is one of ferroelectric substances that allow reduction of temperature changes in relative permittivity. Thus, the use of a ferroelectric material containing barium titanate as a major constituent for the dielectric body 11 constituting the support substrate 1 helps reduce temperature changes in load-carrying capacity, and is also conducive to reduction of temperature changes in oscillation frequency.

As used herein, the term "major constituent" refers to a component which is present in highest amounts in the dielectric body 11.

The first principal surface of the support substrate 1 is provided with the first terminal electrode 121 and the second terminal electrode 122 serving as a pair of terminal electrodes and the first capacitance-forming electrode 123 and the second capacitance-forming electrode 124 serving as a pair of capacitance-forming electrodes.

Each of the first terminal electrode 121 and the second terminal electrode 122 is electrically connected to the excitation electrode 21 of the piezoelectric element 2 for inputting and outputting of signals, and lies in a region below each end of the piezoelectric element 2. It is noted that the region below each end of the piezoelectric element 2 simply refers to a region located below each end, and is thus not limited to a region which exactly overlaps with the piezoelectric element 2 as seen in a plan view.

Moreover, each of the first capacitance-forming electrode 123 and the second capacitance-forming electrode 124 is provided to form capacitance between itself and a grounding electrode 125 which will hereafter be described. The first capacitance-forming electrode 123 extends from the first terminal electrode 121 toward the center of the piezoelectric element 2, and, the configuration of a combination of the first terminal electrode 121 and the first capacitance-forming electrode 123 as seen in a plan view is defined by a convex-shaped electrode pattern. Likewise, the second capacitance-forming electrode 124 extends from the second terminal electrode 122 toward the center of the piezoelectric element 2, and, the configuration of a combination of the second terminal electrode 122 and the second capacitance-forming electrode 124 as seen in a plan view is defined by a convex-shaped electrode pattern. In the example shown in the drawings, the combination of the first terminal electrode 121 and the first capacitance-forming electrode 123 and the combination of the second terminal electrode 122 and the second capacitance-forming electrode 124 are arranged so as to be substantially line-symmetric about an axis corresponding to the center of the piezoelectric element 2, and, a space is left between the tip of the first capacitance-forming electrode 123 and the tip of the second capacitance-forming electrode 124. Moreover, the second principal surface (a lower surface viewing the drawing) of the support substrate 1 is provided with the grounding electrode 125 opposed so as to straddle the first capacitance-forming electrode 123 and the second capacitance-forming electrode 124 with the dielectric body 11 interposed in between, and an input-output electrode 126 for inputting and outputting of signals.

Moreover, the support substrate 1 has side electrodes 127 which extend on a side face thereof from the first principal surface to the second principal surface, and electrically connect the first terminal electrode 121 and the corresponding input-output electrode 126, and the second terminal electrode 122 and the corresponding input-output electrode 126, respectively.

By providing, as in this example, the region where each of the first capacitance-forming electrode 123 and the second capacitance-forming electrode 124 is opposed to the grounding electrode 125 with the dielectric body 11 interposed in between, it is possible to form greater capacitance.

In the case of providing the region where each of the first capacitance-forming electrode 123 and the second capacitance-forming electrode 124 is opposed to the grounding electrode 125 with the dielectric body 11 interposed in between, by designing the facing region between the first capacitance-forming electrode 123 and the grounding electrode 125 and the facing region between the second capacitance-forming electrode 124 and the grounding electrode 125 to be identical in area, the capacitance obtained in the former facing region and the capacitance obtained in the latter facing region become equal. Moreover, the capacitance obtained in each facing region is determined in accordance with the characteristics of an amplifier circuit element which is connected with the piezoelectric component to constitute an oscillation circuit in conjunction with the piezoelectric component.

In FIG. 1, another side electrode 127 is disposed on a part of the side face of the support substrate 1 which is electrically connected to the grounding electrode 125 for purposes of convenience of soldering to an external circuit board.

As the materials for forming the individual electrodes (the first terminal electrode 121, the second terminal electrode 122, the first capacitance-forming electrode 123, the second capacitance-forming electrode 124, the grounding electrode 125, the input-output electrode 126, and the side electrode 127), it is possible to use , for example, a conductive resin material (conductive paste) composed of a resin containing metal powder such for example as gold, silver, copper, aluminum, or tungsten in a dispersed state, and a thick-film conductor obtained by baking of the aforementioned metal powder with an additive such as glass added. The material of construction may be formed with a plating such as a Ni/Au plating or a Ni/Sn plating on an as needed basis.

On the first principal surface of the support substrate 1, a first support portion 31 and a second support portion 32 are disposed, and the ends of the piezoelectric element 2 are mounted on the first support portion 31 and the second support portion 32 so as to be oscillatable. Specifically, both ends in a longitudinal direction of the piezoelectric element 2 are fixed so as to be supported by the first support portion 31 and the second support portion, and the piezoelectric element 2 is mounted so as to be oscillatable.

The first support portion 31 and the second support portion 32 are each designed as a projection-like member made of a resin containing metal powder such for example as gold, silver, copper, aluminum, or tungsten in a dispersed state. For example, each support portion is shaped in a rectangular column or a circular cylinder which is 0.1 mm to 1.0 mm in longitudinal and transverse lengths (in diameter) and 10 µm to 100 µm in height (in thickness).

Moreover, a conductive joining material 4 is disposed on each of the first support portion 31 and the second support portion 32, and each of the first support portion 31 and the second support portion 32 is joined to at least a lower surface of each end of the piezoelectric element 2. As the conductive joining material 4, for example, solder or a conductive adhesive is used. An example of the solder is a lead-free material made of copper, tin, or silver, and, an example of the conductive adhesive is an epoxy conductive resin or a silicone conductive resin that contains conductive particles of silver, copper, nickel, or the like in an amount of 75 to 95% by mass. The first support portion 31 and the second support portion 32 are each made of a material having electrical conductivity, wherefore the arrangement in which the conductive joining material 4 is disposed on each of the first support portion 31 and the second support portion 32 permits conduction between one of the pair of excitation electrodes 21 of the piezoelectric element 2 and the first terminal electrode 121, as well as conduction between the other one of the pair of excitation electrodes 21 and the second terminal electrode 122.

The piezoelectric element 2 is an elongated piezoelectric element comprising a piezoelectric body 22 and the excitation electrodes 21 which are disposed on respective principal surfaces (the first and second principal surfaces) of the piezoelectric body 22 and face each other so that a facing region (intersecting region) is defined therebetween. The piezoelectric body 22 constituting the piezoelectric element 2 is shaped in a flat plate which is rectangular in plan configuration, and is 1.0 mm to 4.0 mm in length, 0.2 mm to 2 mm in width, and 40 µm to 1 mm in thickness, for example. The piezoelectric body 22 may be made of piezoelectric ceramics predominantly composed of, for example, lead titanate, lead zirconate titanate, lithium tantalate, lithium niobate, sodium niobate, potassium niobate, or a bismuth lamellar compound, or made of a single crystal such as lithium niobate or quartz.

Moreover, the excitation electrode 21 on the first principal surface (an upper surface viewing the drawing) of the piezoelectric body 22 is disposed so as to extend from one end toward the other end in the longitudinal direction of the piezoelectric body 22, whereas the excitation electrode 21 on the second principal surface (a lower surface viewing the drawing) of the piezoelectric body 22 is disposed so as to extend from the other end toward one end in the longitudinal direction. That is, these excitation electrodes 21 face each other so that a facing region in which the excitation electrodes 21 overlap with each other as seen in a transparent plan view is defined therebetween. In what follows, the term "the facing region" simply refers to a region where the excitation electrode 21 disposed on the first principal surface and the excitation electrode 21 disposed on the second principal surface overlap with each other as seen in a transparent plan view. The excitation electrodes 21, which may be made of metal such for example as gold, silver, copper, or aluminum, are each laminated in a thickness of, for example, 0.1 µm to 3 µm onto the surface of the piezoelectric body 22. As shown in FIG. 1(b), end electrodes 23 are disposed at respective end faces of the piezoelectric element 2. The excitation electrode 21 disposed on the first principal surface of the piezoelectric body 22 is electrically connected to the first terminal electrode 121 via the end electrode 23 and the first support portion 31 with the conductive joining material 4.

In such a piezoelectric element 2, upon application of a voltage between the excitation electrodes 21, piezoelectric vibration including thickness longitudinal vibration or thickness shear vibration, occurs in the facing region of the excitation electrodes 21 (intersecting region) at a specific frequency.

As shown in FIG. 1(b), the lid body 5 may be disposed on the support substrate 1 so as to accommodate the piezoelectric element 2. The lid body 5 is joined to the edge of the upper surface of the support substrate 1 by an adhesive or other means. This arrangement provides the capability of protection of the piezoelectric element 2, which is accommodated in an internal space defined by the lid body 5 in conjunction with the support substrate 1, from external physical and chemical influences, and also the capability of hermetic sealing to prevent intrusion of foreign matters such as water into the space defined by the lid body 5 in conjunction with the support substrate 1. As the material for forming the lid body 5, for example, it is possible to use metal such as stainless steel, ceramics such as alumina, resin, glass, or the like. Moreover, where an insulating resin material such as epoxy resin is used, the insulating resin material may contain an inorganic filler in an amount of 25 to 80% by mass to reduce the difference in thermal expansion coefficient between the lid body 5 and the support substrate 1.

The pair of capacitance-forming electrodes (the first capacitance-forming electrode 123 and the second capacitance-forming electrode 124), each extending toward the center of the piezoelectric element 2, has a greater width than the piezoelectric element 2.

The pair of capacitance-forming electrodes (the first capacitance-forming electrode 123 and the second capacitance-forming electrode 124) is made greater in width than the piezoelectric element 2, which allows the first capacitance-forming electrode 123 and the second capacitance-forming electrode 124 to have a wider area. This makes it possible to set the load-carrying capacity to a larger value, and thereby reduce oscillation frequency variations.

Moreover, at least part of a region of the pair of capacitance-forming electrodes (the first capacitance-forming electrode 123 and the second capacitance-forming electrode 124) which protrudes outside the facing region in a width direction thereof as seen in a plan view is covered with the insulating film 6. In the example shown in FIG. 1, the insulating film 6 is disposed so as to cover the entire region of the tip portion of the capacitance-forming electrode (the first capacitance-forming electrode 123, the second capacitance-forming electrode 124) which protrudes outside the facing region in the width direction. For example, an insulating resin such as epoxy resin or silicone resin, glass, or ceramics may be used for the insulating film 6.

In the case where at least part of a region of the pair of capacitance-forming electrodes (the first capacitance-forming electrode 123 and the second capacitance-forming electrode 124) which protrudes outside the facing region the width direction is covered with the insulating film 6, in the range of the insulating film 6-bearing region, the first capacitance-forming electrode 123 and the second capacitance-forming electrode 124 can be prevented from being irradiated with ion beams, in consequence whereof there results no change in the area of each of the first capacitance-forming electrode 123 and the second capacitance-forming electrode 124 during ion beam application. This makes it possible to reduce changes in load-carrying capacity even with use of the frequency regulation technology using ion beam application.

The insulating film 6 may be disposed not only on the region of the pair of capacitance-forming electrodes (the first capacitance-forming electrode 123 and the second capacitance-forming electrode 124) which protrudes outside the facing region in the width direction, but also on a region thereof which overlaps the facing region as seen in a transparent plan view.

It is preferable that the insulating film 6 is predominantly composed of resin. The resin-made insulating film 6 is soft and thus has a lower elastic modulus. In this case, it is possible to reduce changes in stress entailed by temperature changes in the support substrate 1, and thereby suppress temperature changes in load-carrying capacity, with consequent further reduction of temperature changes in oscillation frequency.

In particular, it is preferable that the insulating film 6 is made of epoxy resin. The insulating film 6 made of epoxy resin can bring higher heat resistance, and can reduce heat-caused quality degradation under ion beam application. In this case, the insulating film 6 is free of a break even under prolonged ion beam application for frequency regulation, wherefore it is possible to suppress etching of the first capacitance-forming electrode 123 and the second capacitance-forming electrode 124 with ion beams, with consequent further improvement in oscillation frequency precision.

Moreover, the insulating film 6 may be made of a resin containing a filler predominantly composed of an inorganic substance such for example as silica, zirconia, titanium, or fiberglass. In the filler-containing insulating film 6, the filler serves as a barrier against ion beams, thus reducing the amount of ion beams applied to the resin portion of the insulating film 6 that is more heat-sensitive than the filler. In this case, it is possible to impart even higher heat resistance to the insulating film 6, and thereby achieve further reduction of heat-caused quality degradation in the insulating film 6 under ion beam irradiation, with consequent further improvement in oscillation frequency precision. The content of the filler falls in the range of 0.5% to 50% in terms of mass ratio, for example. For example, the filler content may be determined by measuring the mass of a cut piece of the insulating film 6, filtering the resin dissolved in a solvent, measuring the mass of residues (inorganic substance which constitutes the filler), and dividing the mass of the residues by the mass of the insulating film 6.

Moreover, the insulating film 6 may be made of a void-bearing resin. The void-containing insulating film 6 becomes softer (has an even lower elastic modulus). In this case, it is possible to achieve further reduction of changes in the stress applied to the capacitance-forming sections of the support substrate 1 with temperature changes, and thereby suppress changes in load-carrying capacity with temperature changes, with consequent further reduction of temperature changes in oscillation frequency. Note that the proportion of voids contained in the insulating film 6 falls in the range of 2% to 40% in terms of area ratio, for example, as seen in a plan view. The area ratio may be determined by examining the polished surface of the insulating film 6 under a microscope.

Moreover, as shown in FIG. 2, it is preferable that the insulating film 6 extends farther to protrude outside the tip of the capacitance-forming electrode (the first capacitance-forming electrode 123, the second capacitance-forming electrode 124), as well as protrude outside the capacitance-forming electrode in the width direction, as seen in a plan view, so as to cover the side face of the capacitance-forming electrode (the first capacitance-forming electrode 123, the second capacitance-forming electrode 124). This arrangement represents that the insulating film 6 covers both of the end faces at the tips and the side faces in the width direction of the first capacitance-forming electrode 123 and the second capacitance-forming electrode 124. Expressed differently, in this construction, in the range of the insulating film 6-bearing region, neither the first capacitance-forming electrode 123 nor the second capacitance-forming electrode 124 is exposed.

Thus, even if ion beams are applied from an oblique direction, the first capacitance-forming electrode 123 or the second capacitance-forming electrode 124 can be prevented from being irradiated with the ion beams.

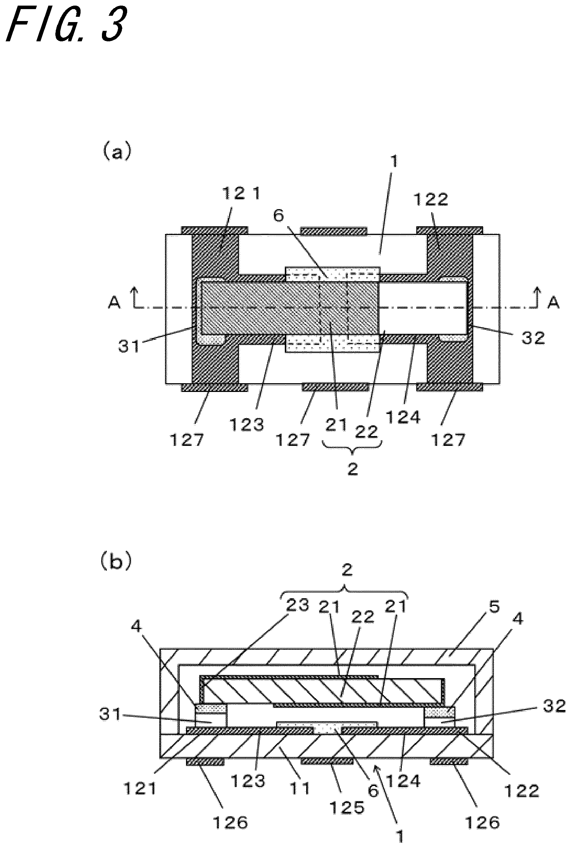

Moreover, in FIG. 2, separate insulating films 6 cover the tip portion of the first capacitance-forming electrode 123 and the tip portion of the second capacitance-forming electrode 124, respectively. In the alternative, as shown in FIG. 3, the insulating film 6 may extend across the pair of capacitance-forming electrodes (the first capacitance-forming electrode 123 and the second capacitance-forming electrode 124). In this case, enhancement can be achieved both in the joining strength of the insulating film 6 and in the effect of protecting the capacitance-forming electrodes.

Moreover, the insulating film 6 may be formed over the entire width of the capacitance-forming electrode (the first capacitance-forming electrode 123, the second capacitance-forming electrode 124), and further protrudes outside the capacitance-forming electrode in the width direction. In this case, the first capacitance-forming electrode 123 or the second capacitance-forming electrode 124 can be prevented from being irradiated with ion beams more effectively, and also, the insulating film 6 can be formed with ease.

In the case where the insulating film 6 is formed over the entire width of each capacitance-forming electrode (the first capacitance-forming electrode 123, the second capacitance-forming electrode 124) while protruding outside each capacitance-forming electrode in the width direction, it is advisable that the insulating film 6 has a width which is less than or equal to 1.7 times that of the capacitance-forming electrode (the first capacitance-forming electrode 123, the second capacitance-forming electrode 124), as seen in a plan view. For example, given that the width of the capacitance-forming electrode (the first capacitance-forming electrode 123, the second capacitance-forming electrode 124) is 1 mm, then the width of the insulating film 6 is less than or equal to 1.7 mm, and, where the protruding parts of the insulating film 6 that protrude outside the capacitance-forming electrode in the width direction are equal in width, the width of each protruding part is adjusted to be less than or equal to 0.35 mm at the maximum. Under normal circumstances, the insulating film 6 is made of a resin or glass material which differs from the material for forming the support substrate 1. In this regard, by adjusting the width of the insulating film 6 to be less than or equal to 1.7 times that of the capacitance-forming electrode (the first capacitance-forming electrode 123, the second capacitance-forming electrode 124), it is possible to reduce a stress which is caused by the difference in thermal expansion coefficient between the support substrate 1 and the insulating film 6 in response to changes in environmental temperature such as thermal cycles. Although the load-carrying capacity varies greatly with changes in stress especially when using a ferroelectric material predominantly composed of lead zirconate titanate or barium titanate for the support substrate 1, by adjusting the width of the insulating film 6 to be less than or equal to 1.7 times that of the capacitance-forming electrode (the first capacitance-forming electrode 123, the second capacitance-forming electrode 124), it is possible to reduce the stress resulting from the difference in thermal expansion coefficient, and thereby reduce oscillation frequency variations.

In the case where the insulating film 6 is formed over the entire width of each capacitance-forming electrode (the first capacitance-forming electrode 123, the second capacitance-forming electrode 124) while protruding outside each capacitance-forming electrode in the width direction, it is advisable that the dimension in the width direction of the insulating film 6 is less than or equal to 1.7 times the width of each of the first capacitance-forming electrode 123 and the second capacitance-forming electrode 124, and that, for example, the insulating film 6 has a width which is 0.1 mm to 0.3 mm greater than the width of the capacitance-forming electrode. More specifically, for example, given that each of the first capacitance-forming electrode 123 and the second capacitance-forming electrode 124 has a width of 0.2 mm to 0.8 mm, then the insulating film 6 is given a width of 0.3 mm to 1.1 mm (the protruding part which protrudes outside the capacitance-forming electrode in the width direction has a width of 0.05 mm to 0.15 mm). Moreover, as to the dimension in the longitudinal direction of the insulating film 6, it is advisable that, in the range of the tip portions of the first capacitance-forming electrode 123 and the second capacitance-forming electrode 124 that overlap with the facing region, the insulating film 6 extends outward, by an amount of 0.05 mm to 0.3 mm, from the position of the end of a region opposed to a region subjected to ion beam application, as well as the end of the region subjected to ion beam application, in the lengthwise direction.

The following describes an example of the method of manufacturing the piezoelectric component of this embodiment.

First, a segmentable substrate for producing the support substrate 1 is prepared. For example, powder of a raw material such as lead zirconate titanate or barium titanate, water, and a dispersant are mixed by a ball mill, and, after the addition of a binder, a plasticizer, and so forth, the mixture is dried and subjected to particle sizing process. The raw material thus obtained is press-molded, and, the molded body is subjected to perforating process on an as needed basis, is degreased at a predetermined temperature, is fired at peak temperatures ranging from, for example, 900°C to 1600°C, and is ground in a predetermined thickness. After that, the individual electrodes are formed by, for example, printing a conductive paste containing metal powder such as silver or nickel and glass, and subsequently performing firing at a predetermined temperature.

Next, the insulating film 6 is formed. That is, for example, a paste of an insulating material such as resin or glass is printed in a manner such that, in each of the first capacitance-forming electrode 123 and the second capacitance-forming electrode 124 as seen in a plan view, at least part of a region thereof which protrudes outside the facing region in the width direction is covered with the insulating film 6, whereafter a curing or firing process is performed at a predetermined temperature. Thus, the support substrate 1 is obtained. As the method of formation, a molding technique such as tape molding or extrusion molding may also be adopted. Moreover, as shown in FIG. 3, in the case where the insulating film 6 is formed so as to extend across the first capacitance-forming electrode 123 and the second capacitance-forming electrode 124, the insulating film 6 can be simply obtained by one paste application step, which will be a manufacturing-process benefit.

On the support substrate 1 thus obtained, the support portions 31 and 32 are formed in a thickness of, for example, 10 µm to 100 µm from a conductive paste by screen printing or otherwise. More specifically, on the first terminal electrode 121, the first support portion 31 in the form of a bump is formed by, for example, solidifying a resin containing dispersed metal powder, and, on the second terminal electrode 122, the second support portion 32 in the form of a bump is formed by, for example, solidifying a resin containing dispersed metal powder.

Next, piezoelectric porcelain (piezoelectric body 22) constituting the piezoelectric element 2 is obtained by, for example, mixing raw material powder, water, and a dispersant together by a ball mill, adding a binder, a plasticizer, and so forth to the mixture, drying the material thus obtained, performing a particle sizing process, press-molding the raw material thus obtained, and performing a firing process. An electrode is formed at the end face of the piezoelectric porcelain thus obtained, and, for example, a voltage of 0.4 kV/mm to 6 kV/mm is applied in an end face direction at a temperature of, for example, 25°C to 300°C to effect polarization.

The excitation electrode 21 formed on each of the upper and lower principal surfaces (the first principal surface and the second principal surface) of the piezoelectric body 22 is obtained by depositing a metallic film on each of the upper and lower surfaces of the piezoelectric body 22 thus obtained by vacuum deposition, PVD, sputtering, or otherwise, forming an about 1 to 10 µm-thick photoresist film on each metallic film by screen printing or otherwise, and performing patterning using photoetching. The piezoelectric element 2 is produced by cutting the patterned piezoelectric body 22 in a predetermined size by dicing or otherwise.

Then, the piezoelectric element 2 is mounted on and fixed to the first support portion 31 and the second support portion 32 of the support substrate 1 via the conductive joining material 4. Where a conductive adhesive made of a resin containing dispersed metal powder is used as the conductive joining material 4, after applying the conductive adhesive onto the first support portion 31 and the second support portion 32 by a dispenser or other means, the piezoelectric element 2 is placed on the first support portion 31 and the second support portion 32, and then, the resin constituting the conductive adhesive is cured by application of heat or under ultraviolet irradiation.

Next, etching to a 0 µm- to 3 µm extent is performed, for example, only on a predetermined to-be-etched region of the excitation electrode 21 formed on the first principal surface of the piezoelectric body 22 by causing collision of charged particle-containing ion beams. This allows adjustment of the mass (thickness and area) of the excitation electrode 21 to achieve predetermined frequency regulation.

Then, the surface at the opening edge of the lid body 5 is joined to the periphery of the upper surface of the support substrate 1 so as to cover the piezoelectric element 2. A segmentable lid cluster sheet having a plurality of recesses is used to form the lid body 5. The lid cluster sheet is placed on the segmentable substrate, with each recess positioned so as to cover the piezoelectric element 2, and, the projecting part of the lid cluster sheet that acts as the surface of the opening edge of the lid body 5 is joined to the periphery of the upper surface of the support substrate 1. For example, a thermosetting insulating adhesive is applied to the projecting part of the prepared lid cluster sheet that acts as the surface of the opening edge of the lid body 5, and, the lid body 5 is placed on the upper surface of the support substrate 1. After that, the lid body 5 or the support substrate 1 is subjected to heat to raise the temperature of the insulating adhesive to 100 to 150°C to cure the insulating adhesive. Thus, the lid body 5 can be joined to the upper surface of the support substrate 1.

Finally, the obtained resultant is cut along the boundaries among pieces of piezoelectric components by dicing, wire cutting, or otherwise.

The piezoelectric component of this embodiment is produced in accordance with the method thus far described. The above-described method enables production of piezoelectric components in which oscillation frequency variations can be reduced with consequent improvement in oscillation frequency precision with high productivity.

### Reference Signs List

1: Support substrate
11: Dielectric body
121: First terminal electrode
122: Second terminal electrode
123: First capacitance-forming electrode
124: Second capacitance-forming electrode
125: Grounding electrode
126: Input-output electrode
127: Side electrode
2: Piezoelectric element
21: Excitation electrode
22: Piezoelectric body
23: End electrode
31: First support portion
32: Second support portion
4: Conductive joining material
5: Lid body
6: Insulating film

## Claims

1. A piezoelectric component, comprising:
a support substrate;
a piezoelectric element having both ends fixed to a first principal surface of the support substrate, being mounted on the first principal surface, so as to be oscillatable;
a pair of terminal electrodes located below the ends of the piezoelectric element, respectively;
a pair of capacitance-forming electrodes each having a greater width than the piezoelectric element extending from the pair of terminal electrodes, respectively, toward a center of the piezoelectric element; and
excitation electrodes disposed on a first principal surface and a second principal surface of the piezoelectric element, respectively, the excitation electrodes facing each other so that a facing region in which the excitation electrodes overlap with each other as seen in a transparent plan view is defined therebetween,
at least part of a region of the pair of capacitance-forming electrodes which protrudes outside the facing region in a width direction thereof as seen in a plan view, being covered with an insulating film.

2. The piezoelectric component according to claim 1,
wherein the insulating film protrudes outside a tip of each of the capacitance-forming electrodes, as well as protrudes outside each of the capacitance-forming electrodes in the width direction, so as to cover a side face of each of the capacitance-forming electrodes.

3. The piezoelectric component according to claim 1 or 2,
wherein the insulating film extends across the pair of capacitance-forming electrodes.

4. The piezoelectric component according to any one of claims 1 to 3,
wherein the insulating film extends over an entire width of each of the capacitance-forming electrodes, and further protrudes outside both ends in the width direction of each of the capacitance-forming electrodes.

5. The piezoelectric component according to claim 4,
wherein the insulating film has a width which is less than or equal to 1.7 times a width of each of the capacitance-forming electrodes, as seen in a plan view.

6. The piezoelectric component according to any one of claims 1 to 5,
wherein the insulating film is predominantly composed of a resin.

7. The piezoelectric component according to claim 6,
wherein the resin is made of epoxy resin.

8. The piezoelectric component according to claim 6 or 7,
wherein the insulating film contains a filler made of an inorganic material.

9. The piezoelectric component according to any one of claims 1 to 8,
wherein the insulating film contains voids.
